# EUROPÄISCHE PATENTANMELDUNG

(11) **EP 0 974 977 A2**
(43) Veröffentlichungstag der Anmeldung: **26.01.2000**
(21) Anmeldenummer: 99112580.8
(22) Anmeldetag: 01.07.1999
(51) Int. Cl.: G11C 8/00

(54) **Integrierter Speicher**

(30) Priorität: 06.07.1998 DE 19830111
(71) Anmelder: SIEMENS AKTIENGESELLSCHAFT, 80333 München (DE)
(72) Erfinder: Schöniger, Sabine, 81737 München (DE); Schrögmeier, Peter, 81547 München (DE); Hein, Thomas, 81667 München (DE); Dietrich, Stefan, Dr., 82299 Türkenfeld (DE); Marx, Thilo, 80997 München (DE)

(57) **Zusammenfassung**

Der integrierte Speicher weist einen Spaltendecoder (CDEC) auf zum Decodieren von Spaltenadressen und zum Adressieren von entsprechenden Bitleitungen (BL). Ferner weist er einen ersten Spaltenadreßbus (CADR1) auf, über den erste Spaltenadressen zum Spaltendecoder übertragen werden, sowie einen zweiten Spaltenadreßbus (CADR2), über den zweite Spaltenadressen zum Spaltendecoder übertragen werden. Dabei adressiert der Spaltendecoder jeweils Bitleitungen, die den ihm zugeführten ersten bzw. zweiten Spaltenadressen entsprechen.

## Beschreibung

Die Erfindung betrifft einen integrierten Speicher mit einem Spaltendecoder zum Decodieren von Spaltenadressen und zum Adressieren von entsprechenden Bitleitungen.

Ein solcher integrierter Speicher in Form eines DRAMs ist beispielsweise in U. Tietze, Ch. Schenk: "Halbleiterschaltungstechnik", 10. Auflage, Springer-Verlag Berlin, 1993, in Abbildung 11.9 dargestellt. Wie allgemein üblich, weist das RAM auch einen Zeilendecoder zum Decodieren von Zeilenadressen und zum Adressieren von entsprechenden Wortleitungen auf. Alle Spaltenadressen werden dem Spaltendecoder über einen Spaltenadreßbus zugeführt, die Zeilenadressen werden dem Zeilendecoder über einen Zeilenadreßbus zugeführt.

Der Erfindung liegt die Aufgabe zugrunde, einen integrierten Speicher anzugeben, bei dem die Zuführung der Spaltenadressen zum Spaltendecoder auf andere Weise erfolgt.

Diese Aufgabe wird mit einem integrierten Speicher gemäß Anspruch 1 gelöst. Vorteilhafte Aus- und Weiterbildungen der Erfindung sind Gegenstand abhängiger Ansprüche.

Der erfindungsgemäße integrierte Speicher weist einen Spaltendecoder zum Decodieren von Spaltenadressen und zum Adressieren von entsprechenden Bitleitungen auf. Weiterhin weist er einen ersten Spaltenadreßbus auf, über den erste Spaltenadressen zum Spaltendecoder übertragen werden, sowie einen zweiten Spaltenadreßbus, über den zweite Spaltenadressen zum Spaltendecoder übertragen werden, wobei der Spaltendecoder jeweils diejenigen Bitleitungen adressiert, die den ihm zugeführten ersten bzw. zweiten Spaltenadressen entsprechen.

Bei herkömmlichen Speichern ist lediglich ein Spaltenadreßbus zur Zuführung aller Spaltenadressen vorgesehen. Somit können Spaltenadressen über diesen einen Spaltenadreßbus nur sequentiell zum Spaltendecoder übertragen werden. Bei der Erfindung werden die Spaltenadressen dagegen über zwei verschiedene Spaltenadreßbusse übertragen.

Die Erfindung bietet den Vorteil, daß zeitlich unabhängig voneinander Spaltenadressen zur Adressierung unterschiedlicher Bitleitungen sowohl über den ersten als auch über den zweiten Spaltenadreßbus übertragen werden können. Somit können Spaltenadressen beispielsweise über den ersten Spaltenadreßbus zum Spaltendecoder übertragen werden, während der zweite Spaltenadreßbus nicht verfügbar ist, weil er für andere Aufgaben benötigt wird. Durch die Erfindung ist es möglich, Zeitverluste, die aufgrund der Signallaufzeiten der Spaltenadressen auf den Spaltenadreßbussen entstehen, zu reduzieren, da eine Spaltenadresse bereits über den ersten Spaltenadreßbus zum Spaltendecoder transportiert werden kann, während der zweite Spaltenadreßbus noch eine vorhergehende Spaltenadresse am Spaltendecoder bereitstellt.

Nach einer Weiterbildung der Erfindung weist der Speicher ein erstes Taktsignal auf, in dessen Abhängigkeit die am ersten Spaltenadreßbus anliegenden ersten Spaltenadressen dem Spaltendecoder zugeführt werden und ein zweites Taktsignal, in dessen Abhängigkeit die auf dem zweiten Spaltenadreßbus anliegenden zweiten Spaltenadressen dem Spaltendecoder zugeführt werden. Es ist dann möglich, die ersten bzw. zweiten Spaltenadressen über den entsprechenden Spaltenadreßbus bis direkt zum Spaltendecoder zu transportieren und dann über das erste bzw. zweite Taktsignal zum gewünschten Zeitpunkt der Decodierung durch den Spaltendecoder zuzuführen. Dies hat den Vorteil, daß lange Signallaufzeiten, die sich aufgrund im allgemeinen langer Adreßbusse ergeben, bei der Decodierung durch den Spaltendecoder nicht mehr zu berücksichtigen sind, wenn das erste und das zweite Taktsignal zeitlich so abgestimmt sind, daß die entsprechenden Spaltenadressen bereits über die Adreßbusse zum Spaltendecoder übertragen worden sind.

Nach einer Weiterbildung der Erfindung weist der Speicher Adreßeingänge zum Anlegen der ersten Spaltenadressen an den Speicher auf, die mit dem ersten Spaltenadreßbus und einem Adreßzähler verbunden sind. Ferner weist der Speicher eine Steuereinheit zum Laden einer der an den Adreßeingängen anliegenden ersten Spaltenadressen in den Adreßzähler als dessen Startadresse auf, wobei der Adreßzähler durch das zweite Taktsignal gesteuert ist. Außerdem wird für eine bestimmte Anzahl von Zyklen des zweiten Taktsignals jeweils der Inhalt des Adreßzählers als eine der zweiten Spaltenadressen auf den zweiten Spaltenadreßbus gegeben.

Bei dieser Ausführungsform ist es also möglich, die erste Spaltenadresse direkt von den Adreßeingängen über den ersten Spaltenadreßbus zum Spaltendecoder zu übertragen und zeitlich parallel hierzu diese erste Spaltenadresse als Startadresse des Adreßzählers in diesen zu laden. Das bedeutet, daß der Spaltendecoder bereits eine der ersten Spaltenadresse entsprechende Bitleitung adressiert, während mittels des Adreßzählers die erste der zweiten Spaltenadressen generiert wird. Mit jedem Zyklus des zweiten Taktsignals wird der Inhalt des Adreßzählers über den zweiten Spaltenadreßbus wiederum in Abhängigkeit des zweiten Taktsignals ebenfalls dem Spaltendecoder zugeführt, woraufhin dieser jeweils den zweiten Spaltenadressen entsprechende andere Bitleitungen adressiert. Diese Ausführungsform der Erfindung eignet sich also zur Realisierung eines Burst-Zugriffs auf die Bitleitungen des Speichers, bei dem von extern an die Adreßeingänge lediglich jeweils eine erste Spaltenadresse angelegt wird, woraufhin mittels des Adreßzählers und des zweiten Spaltenadreßbusses eine festgelegte Anzahl von zweiten Spaltenadressen ebenfalls zum Spaltendecoder übertragen werden. Folglich werden bei Anlegen einer der ersten Spaltenadressen nacheinander immer mehrere der Bitleitungen durch den Spaltendecoder adressiert.

Bei einer Weiterbildung der Erfindung erfolgt die Zuführung der ersten Spaltenadresse zum Spaltendecoder ebenso wie das Laden der ersten Spaltenadresse in den Adreßzähler gesteuert durch das erste Taktsignal. Dies hat den Vorteil der zeitlichen Parallelität der Decodierung der ersten Spaltenadresse und Generierung der zweiten Spaltenadressen.

Nach einer Weiterbildung ist der erste Spaltenadreßbus gleichzeitig ein Zeilenadreßbus, über den im Zeitmultiplex zur Übertragung der ersten Spaltenadressen zusätzlich Zeilenadressen von den Adreßeingängen zu einem Zeilendecoder übertragen werden, der zum Adressieren von Wortleitungen dient. Ferner weist der Speicher ein drittes Taktsignal auf, in dessen Abhängigkeit die auf dem ersten Spaltenadreßbus anliegenden Zeilenadressen dem Zeilendecoder zugeführt werden. Diese Weiterbildung bietet den Vorteil, daß trotz Vorhandenseins der beiden Spaltenadreßbusse aufgrund der Doppelausnutzung des ersten Spaltenadreßbusses als Zeilenadreßbus keine größere Anzahl von Adreßbussen notwendig ist, als bei herkömmlichen Speichern. Wie einleitend erwähnt, weisen herkömmliche Speicher einen einzigen Spaltenadreßbus und einen davon getrennten Zeilenadreßbus auf, also insgesamt zwei Adreßbusse.

Bei der Erfindung wird durch das dritte Taktsignal ermöglicht, auf dem ersten Spaltenadreßbus anliegende Spaltenadressen, die in Abhängigkeit vom ersten Taktsignal dem Spaltendecoder zuzuführen sind, von auf dem ersten Spaltenadreßbus anliegenden Zeilenadressen, die in Abhängigkeit des dritten Taktsignals dem Zeilendecoder zuzuführen sind, zu unterscheiden.

Die Erfindung wird im folgenden anhand der Figuren näher erläutert.
- Figur 1: zeigt ein Ausführungsbeispiel des erfindungsgemäßen integrierten Speichers und
- Figur 2: zeigt Taktsignale zum Ausführungsbeispiel aus Figur 1.

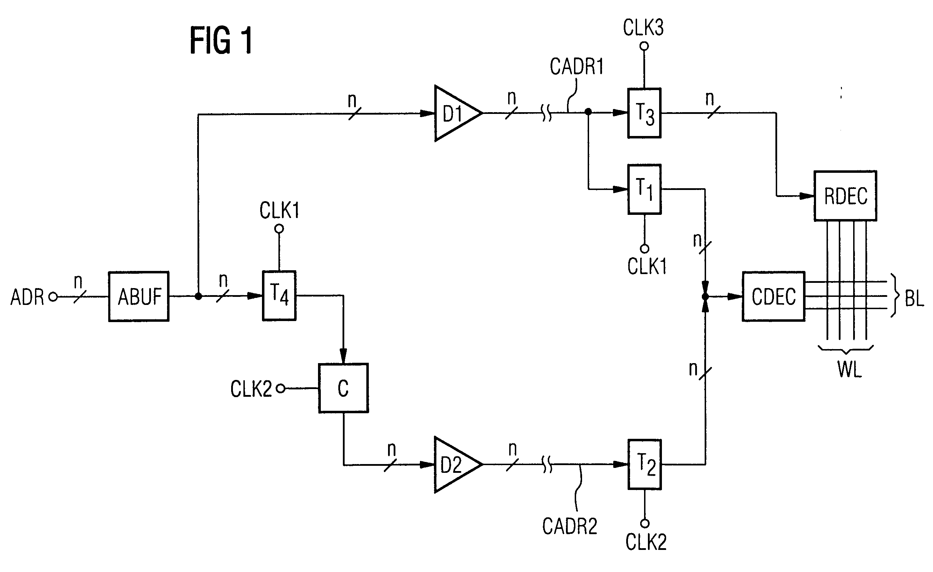

Der erfindungsgemäße integrierte Speicher gemäß Figur 1 ist ein DRAM. Die Erfindung ist jedoch nicht auf DBAMs beschränkt, sondern kann auch auf alle anderen Arten von Speichern angewendet werden, bei denen eine Adressierung von Spaltenleitungen über Spaltenadressen erfolgt. Das DRAM weist matrixförmig entlang von Bitleitungen BL und Wortleitungen WL angeordnete Speicherzellen auf. Die Bitleitungen sind über einen Spaltendecoder CDEC und die Wortleitungen über einen Zeilendecoder RDEC adressierbar. Zur Adressierung der Bitleitungen werden dem Spaltendecoder CDEC entsprechende Spaltenadressen zugeführt. Ebenso werden zur Adressierung der Wortleitungen dem Zeilendecoder RDEC entsprechende Zeilenadressen zugeführt. Insofern unterscheidet sich das DRAM nicht von herkömmlichen Speichern. Das Wesentliche der Erfindung ist, daß im Gegensatz zu herkömmlichen Speichern die Spaltenadressen dem Spaltendecoder CDEC über zwei verschiedene Spaltenadreßbusse zugeführt werden, nämlich über einen ersten Spaltenadreßbus CADR1 und einen zweiten Spaltenadreßbus CADR2. Dabei werden die auf dem ersten Spaltenadreßbus CADR1 anliegenden Spaltenadressen über ein mit einem ersten Taktsignal CLK1 getaktetes erstes Transfergate T1 und die auf dem zweiten Spaltenadreßbus CADR2 befindlichen Spaltenadressen über ein zweites Tranfergate T2, das mit einem zweiten Taktsignal CLK2 getaktet ist, dem Spaltendecoder CDEC zugeführt.

Bei anderen Ausführungsbeispielen der Erfindung ist es möglich, sowohl dem ersten als auch dem zweiten Spaltenadreßbus Spaltenadressen zuzuführen, die jeweils extern an den Speicher angelegt werden. Beim in Figur 1 dargestellten Ausführungsbeispiel ist dies jedoch nicht der Fall. Der Speicher weist Adreßeingänge ADR auf, über die von extern angelegte Spaltenadressen einem Adreßpuffer ABUF zugeführt werden, wo sie zwischengespeichert werden. Diese von extern an den Speicher angelegten Spaltenadressen sollen im folgenden erste Spaltenadressen genannt werden. Aus dem Adreßpuffer ABUF wird die erste Spaltenadresse einerseits über einen Treiber D und den ihm nachgeschalteten ersten Spaltenadreßbus CADR1 zum mit dem ersten Taktsignal CLK1 getakteten ersten Transfergate T1 übertragen, das dem Spaltendecoder CDEC direkt vorgeschaltet ist. Andererseits wird gleichzeitig die erste Spaltenadresse über ein ebenfalls mit dem ersten Taktsignal CLK1 getaktetes viertes Transfergate T4 in das Register eines Adreßzählers C übertragen, wo sie eine Startadresse des Zählers bildet. Der Zähler C selbst ist mit dem zweiten Taktsignal CLK2 getaktet. Mit jedem Zyklus des zweiten Taktsignals CLK2 erhöht der Zähler seinen Zählerstand und gibt eine entsprechende neu berechnete zweite Spaltenadresse an seinen Ausgang aus. Diese mit jedem Taktzyklus des zweiten Taktsignals neu erzeugte zweite Spaltenadresse wird über einen Treiber D und den ihm nachgeschalteten zweiten Spaltenadreßbus CADR2 zum dem Spaltendecoder CDEC vorgeschalteten und mit dem zweiten Taktsignal getakteten zweiten Transfergate T2 übertragen.

Durch nicht weiter im einzelnen dargestellten Komponenten ist es möglich, den Adreßzähler C nach einer vorgegebenen Anzahl von Taktzyklen des zweiten Taktsignals CLK2 zu stoppen und auf die Zuführung einer neuen ersten Spaltenadresse als Startadresse vorzubereiten. Auf die geschilderte Weise ist es möglich, einen Burstzugriff auf die Bitleitungen BL des Speichers durchzuführen, bei dem nur eine einzige erste Spaltenadresse an die Adreßeingänge ADR angelegt wird, woraufhin automatisch eine vorgegebene Anzahl der Bitleitungen BL zeitlich nacheinander adressiert wird. Dies geschieht dadurch, daß einerseits die angelegte erste Spaltenadresse direkt über den ersten Spaltenadreßbus CADR1 dem Spaltendecoder CDEC zugeführt wird und andererseits die durch den Adreßzähler C generierten zweiten Spaltenadressen über den zweiten Spaltenadreßbus CADR2 zum Spaltendecoder CDEC übertragen werden.

Durch die Anordnung des ersten Transfergates T1 am Ende des ersten Spaltenadreßbus CADR1 direkt vor dem Spaltendecoder CDEC wird erreicht, daß die vom ersten Treiber D1 über den ersten Spaltenadreßbus CADR1 getriebene erste Spaltenadresse nur noch eine zu vernachlässigende Signallaufzeit für die Strecke vom ersten Transfergate T1 zum Spaltendecoder CDEC benötigt. Bei den heutigen Abmessungen von integrierten Speichern befinden sich dagegen die Adreßeingänge ADR sehr weit entfernt von den Spaltendecodern, so daß die Spaltenadreßbusse eine große Länge aufweisen, die mit nicht zu vernachlässigenden Signallaufzeiten verbunden sind.

Während es bei anderen Ausführungsbeispielen der Erfindung möglich ist, die Zeilenadressen dem Zeilendecoder RDEC über einen separaten Zeilenadreßbus zuzuführen, wodurch insgesamt drei Adreßbusse (nämlich zwei Spaltenadreßbusse und ein Zeilenadreßbus) benötigt werden, sind beim Ausführungsbeispiel in Figur 1 günstigerweise insgesamt nur zwei Adreßbusse (nämlich die beiden Spaltenadreßbusse CADR1 und CADR2) vorhanden. Die Zeilenadressen werden gemäß Figur 1 nämlich ebenfalls über den ersten Spaltenadreßbus CADR1 übertragen. An die Adreßeingänge ADR sind also (im Zeitmultiplex) nicht nur erste Spaltenadressen, sondern auch Zeilenadressen anlegbar, die über den Adreßpuffer ABUF und den ersten Treiber D1 sowie den diesem nachgeschaltenen ersten Spaltenadreßbus CADR1 zu einem dritten Transfergate T3 übertragen werden, daß mit einem dritten Taktsignal CLK3 getaktet ist. Vom dritten Transfergate T3 werden die Zeilenadressen in Abhängigkeit vom dritten Taktsignal CLK3 zum Zeilendecoder RDEC übertragen. Da das erste Transfergate T1 mit dem ersten Taktsignal CLK1 und das dritte Transfergate T3 mit dem dritten Taktsignal CLK3 getaktet ist, ist es möglich, mittels der genannten Taktsignale zu unterscheiden, ob die auf dem ersten Spaltenadreßbus CADR1 anliegenden Adressen als erste Spaltenadresse oder als Zeilenadresse behandelt wird.

Figur 1 ist auch zu entnehmen, daß die Adreßeingänge ADR die Anzahl n haben und daß auch die Spaltenadreßbusse CADR1, CADR2 eine Breite von n Bit haben. Somit sind sowohl erste Spaltenadressen als auch zweite Spaltenadressen mit der Breite n Bit übertragbar. Außerdem haben beim gezeigten Ausführungsbeispiel auch die Zeilenadressen die Breite n Bit. Bei anderen Ausführungsformen der Erfindung ist es selbstverständlich auch möglich, daß der erste Spaltenadreßbus CADR1 eine größere Bitbreite aufweist als der zweite Spaltenadreßbus CADR2. Dies ist beispielsweise der Fall, wenn die Zeilenadressen eine größere Bitbreite als die Spaltenadressen aufweisen. Der erste Spaltenadreßbus CADR1 muß dann die größere Breite der Zeilenadressen aufweisen. Für die Übertragung der ersten Spaltenadressen über den ersten Spaltenadreßbus CADR1 werden dann nicht alle seine Leitungen benötigt.

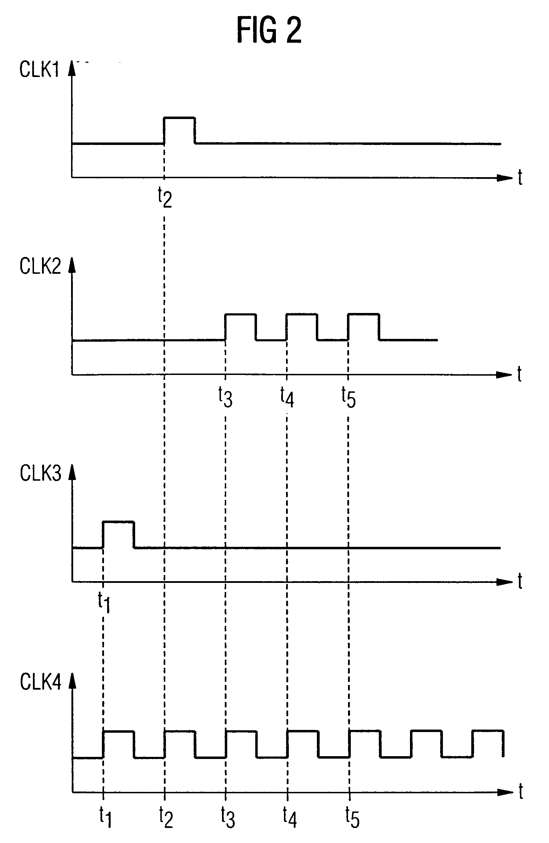

In Figur 2 ist beispielhaft der Verlauf der ersten bis dritten Taktsignale CLK1 bis CLK3 dargestellt, die aus einem dem integrierten Speicher beispielsweise von extern zugeführten vierten Taktsignal CLK4 mit konstanter Taktperiode abgeleitet sind. Für die in Figur 2 dargestellten Taktsignal CLK1 bis CLK3 ist angenommen, daß das entsprechende durch sie gesteuerte Transfergate T1 bis T4 in Figur 1 immer bei einem hohen Pegel des jeweiligen Taktsignals leitend ist und bei einem niedrigen Pegel sperrt. Im folgenden wird ein Adressierungsvorgang im Rahmen eines Schreib- oder Lesezugriffs auf den Speicher beschrieben.

Zu einem ersten Zeitpunkt t1 weist das dritte Taktsignal CLK3 in Figur 2 kurzzeitig einen hohen Pegel auf, so daß eine zu diesem Zeitpunkt an den Adreßeingängen ADR anliegende Zeilenadresse über den ersten Spaltenadreßbus CADR1 und das dritte Transfergate T3 zum Zeilendecoder RDEC übertragen wird. Der Zeilendecoder aktiviert daraufhin die entsprechende Wortleitung. Zu einem zweiten Zeitpunkt t2 weist das erste Taktsignal CLK1 kurzzeitig einen hohen Pegel auf, so daß eine zu diesem Zeitpunkt an den Adreßeingängen ADR anliegende erste Spaltenadresse, die über den ersten Spaltenadreßbus CADR1 am ersten Transfergate T1 anliegt, über dieses zum Spaltendecoder CDEC übertragen wird. Letzterer adressiert eine entsprechende Bitleitung. Gleichzeitig zur Übertragung der ersten Spaltenadresse über das erste Transfergate T1 zum Spaltendecoder wird die erste Spaltenadresse über das vierte Transfergate T4, das ebenfalls mit dem ersten Taktsignal CLK1 getaktet ist, in den Adreßzähler C geladen. Zu weiteren Zeitpunkten t3, t4, t5 weist das zweite Taktsignal CLK2 kurzzeitig hohe Pegel auf, wodurch jedesmal die im Adreßzähler C gespeicherte Startadresse inkrementiert wird. Mit jedem Zyklus des zweiten Taktsignals CLK2 wird der Zählerstand des Adreßzählers C über den zweiten Spaltenadreßbus CADR2 zum zweiten Transfergate T2 übertragen. Von dort wird er als zweite Spaltenadresse, ebenfalls in Abhängigkeit vom zweiten Taktsignal CLK2, zum Spaltendecoder CDEC übertragen.

Günstigerweise gibt der Adreßzähler C bereits nach dem zum zweiten Zeitpunkt t2 auftretenden hohen Pegel des ersten Taktsignals CLK1 an seinen Ausgang eine zweite Spaltenadresse aus, die um das vorgegebene Inkrement größer ist als die erste Spaltenadresse. Dann kann schon vor dem ersten Puls des zweiten Taktsignals CLK2 diese zweite Spaltenadresse zum zweiten Transfergate T2 übertragen werden. Mit dem zum Zeitpunkt t3 auftretenden Puls des zweiten Taktsignals CLK2 kann dann bereits die erste der zweiten Spaltenadressen direkt vom Eingang des zweiten Transfergates T2 zum Spaltendecoder CDEC übertragen werden. Somit wird erreicht, daß die Laufzeit der zweiten Spaltenadresse auf dem zweiten Spaltenadreßbus CADR2 anfällt, während noch die erste Spaltenadresse vom Spaltendecoder CDEC decodiert wird. Die dem Spaltendecoder CDEC mit jedem folgenden Taktzyklus des zweiten Taktsignals CLK2 zugeführten zweiten Spaltenadressen werden von diesem ebenfalls decodiert und führen zur Adressierung jeweils entsprechender Bitleitungen BL.

Da die anfangs zum Zeitpunkt t1 durch den Zeilendecoder RDEC adressierte Wortleitung WL die ganze Zeit aktiviert bleibt, kann auf die beschriebene Weise durch nachfolgende Zuführung der ersten Spaltenadresse und der zweiten Spaltenadressen zum Spaltendecoder CDEC jeweils ein Datum aus dem Speicher ausgelesen oder in ihn hineingeschrieben werden.

Das geschilderte Ausführungsbeispiel aus Figur 1 eignet sich zur Anwendung in solchen Speichern, bei denen die Zeilenadressen und die erste Spaltenadressen nacheinander den Adreßeingängen ADR zugeführt werden. Da anschließend die Generierung der zweiten Spaltenadressen aus der ersten Spaltenadresse mittels des Adreßzählers C automatisch innerhalb des Speichers erfolgt, kann der erste Spaltenadreßbus CADR1 bereits parallel hierzu der Zuführung einer neuen an den Adreßeingängen ADR anliegenden Zeilenadresse über den ersten Spaltenadreßbus CADR1 zum dritten Transfergate T3 dienen. Hierdurch wird bei einem erneuten Beginn des anhand von Figur 2 erläuterten Adressierungszyklus' die nächste mit dem dritten Taktsignal CLK3 zuzuführende Zeilenadresse bereits frühzeitig am dritten Transfergate T3 bereitgestellt, so daß Signallaufzeiten auf dem ersten Spaltenadreßbus CADR1 bei der anschließend durchzuführenden Decodierung der Zeilenadresse nicht mehr berücksichtigt werden müssen.

Das zuletzt geschilderte Ausführungsbeispiel eignet sich vorteilhaft zum Einsatz in integrierten Speichern, die eine größere Anzahl von Speicherblöcken bzw. Speicherbänken aufweisen, von denen jeder wie im rechten Teil von Figur 1 dargestellt organisiert ist. Das heißt, daß jeder Block einen Spaltendecoder, einen Zeilendecoder sowie Steuerschaltungen aufweist, die dem ersten bis dritten Transfergate T1, T2, T3 in Figur 1 entsprechen. Dabei sind die Transfergates T1, T2, T3 der verschiedenen Bänke alle mit dem gleichen ersten und dem gleichen zweiten Spaltenadreßbus verbunden.

Indem die genannten drei Steuerschaltungen mit unterschiedlichen Steuersignalen angesteuert werden, ist es möglich, diesen Speicher im sogenannten Multibank-Betrieb zu betreiben, in dem jeweils eine Bank aktiviert und die anderen Bänke deaktiviert sind. Dabei bedeutet "deaktivierte Bank" in diesem Zusammenhang eine Bank, in der über den Zeilendecoder zwar Wortleitungen aktivierbar sind, in der aber keine Bitleitungen über den Spaltendecoder selektiert werden können. Bei einem derartigen Speicher ist es möglich, während eines Spaltenadreßbursts, der gerade in der jeweils aktivierten Speicherbank durchgeführt wird, einer der deaktivierten Bänke über den ersten Spaltenadreßbus CADR1 bereits eine neue Zeilenadresse für einen anschließend durchzuführenden neuen Spaltenadreßburst zuzuführen. In der letztgenannte Bank kann dann bereits die neue Zeilenadresse decodiert und die entsprechende Wortleitung aktiviert werden, während in der derzeit aktiven Bank noch die zweiten Spaltenadressen generiert, über den zweiten Spaltenadreßbus übertragen und decodiert werden. Erst nach Abschluß ihres Burstzugriffs wird die erste Bank deaktiviert und die zweite Bank aktiviert, woraufhin in der zweiten Bank durch Zuführung einer neuen ersten Spaltenadresse der gewünschte Burstzugriff gestartet wird.

Auf die geschilderte Weise ergibt sich ein Geschwindigkeitsvorteil, da neue Zeilenadressen bereits sehr frühzeitig an den entsprechenden Zeilendecodern bereitgestellt und noch während des vorhergehenden Burstzugriffs auf eine andere Bank decodiert werden. Bei einem Bankwechsel kann dann sofort mit der Zuführung der ersten Spaltenadresse begonnen werden, da die zugehörige Zeilenadresse bereits vor dem Bankwechsel (Wechsel der aktiven Bank) decodiert worden ist.

## Patentansprüche

1. Integrierter Speicher
- mit einem Spaltendecoder (CDEC) zum Decodieren von Spaltenadressen und zum Adressieren von entsprechenden Bitleitungen (BL),
- mit einem ersten Spaltenadreßbus (CADR1), über den erste Spaltenadressen zum Spaltendecoder (CDEC) übertragen werden,
- und mit einem zweiten Spaltenadreßbus (CADR2), über den zweite Spaltenadressen zum Spaltendecoder übertragen werden,
- wobei der Spaltendecoder jeweils Bitleitungen adressiert, die den ihm zugeführten ersten bzw. zweiten Spaltenadressen entsprechen.

2. Speicher nach Anspruch 1,
- mit einem ersten Taktsignal (CLK1), in dessen Abhängigkeit die auf dem ersten Spaltenadreßbus (CADR1) anliegenden ersten Spaltenadressen dem Spaltendecoder (CDEC) zugeführt werden,
- und mit einem zweiten Taktsignal (CLK2), in dessen Abhängigkeit die auf dem zweiten Spaltenadreßbus (CADR2) anliegenden zweiten Spaltenadressen dem Spaltendecoder zugeführt werden.

3. Speicher nach Anspruch 2,
- mit Adreßeingängen (ADR) zum Anlegen der ersten Spaltenadressen an den Speicher, die mit dem ersten Spaltenadreßbus (CADR1) und einem Adreßzähler (C) verbunden sind,
- mit einer Steuereinheit (T4) zum Laden einer der an den Adreßeingängen (ADR) anliegenden ersten Spaltenadressen in den Adreßzähler (C) als dessen Startadresse,
- wobei der Adreßzähler durch das zweite Taktsignal (CLK2) gesteuert ist,
- und wobei für eine bestimmte Anzahl von Zyklen des zweiten Taktsignals jeweils der Inhalt des Adreßzählers als eine der zweiten Spaltenadressen auf den zweiten Spaltenadreßbus (CADR2) gegeben wird.

4. Speicher nach Anspruch 3,
bei dem die Steuereinheit (T4) zum Laden der Startadresse in den Adreßzähler (C) durch das erste Taktsignal (CLK1) gesteuert ist.

5. Speicher nach Anspruch 4,
- dessen erster Spaltenadreßbus (CADR1) gleichzeitig ein Zeilenadreßbus ist, über den im Zeitmultiplex zur Übertragung der ersten Spaltenadressen zusätzlich Zeilenadressen von den Adreßeingängen (ADR) zu einem Zeilendecoder (RDEC) übertragen werden, der zum Adressieren von Wortleitungen (WL) dient,
- und der ein drittes Taktsignal (CLK3) aufweist, in dessen Abhängigkeit die auf dem ersten Spaltenadreßbus (CADR1) anliegenden Zeilenadressen dem Zeilendecoder (RDEC) zugeführt werden.
